# EUROPÄISCHE PATENTSCHRIFT

(11) **EP 4 248 721 B1**
(45) Veröffentlichungstag und Bekanntmachung des Hinweises auf die Patenterteilung: **10.09.2025**
(21) Anmeldenummer: 21799184.3
(22) Anmeldetag: 21.10.2021
(51) Int. Cl.: H05K 7/20, F28F 9/18

(54) **KÜHLSYSTEM ZUR FLÜSSIGKEITSIMMERSIONSKÜHLUNG VON ELEKTRONISCHEN BAUTEILEN**
COOLING SYSTEM FOR THE LIQUID IMMERSION COOLING OF ELECTRONIC COMPONENTS
SYSTÈME DE REFROIDISSEMENT POUR LE REFROIDISSEMENT EN IMMERSION LIQUIDE DE COMPOSANTS ÉLECTRONIQUES

(30) Priorität: 17.11.2020 DE 102020007021
(43) Veröffentlichungstag der Anmeldung: 27.09.2023
(73) Patentinhaber: Wieland-Werke AG, 89079 Ulm (DE)
(72) Erfinder: GAIBLER, Harald, 89616 Rottenacker (DE); GOTTERBARM, Achim, 89160 Dornstadt (DE); HOFMANN, Philipp, 89264 Weißenhorn (DE); OBST, Verena, 89231 Neu-Ulm (DE); SCHEUSS, Michael, 50999 Köln (DE)
(86) Internationale Anmeldenummer: PCT/EP2021/000128
(87) Internationale Veröffentlichungsnummer: WO 2022/106046

(56) Entgegenhaltungen:
- US-A- 5 099 908
- US-A1- 2014 218 858
- US-A1- 2019 008 077
- US-B2- 10 512 192

## Beschreibung

Die Erfindung betrifft ein Kühlsystem zur Flüssigkeitsimmersionskühlung von elektronischen Bauteilen gemäß dem Oberbegriff des Anspruchs 1.

Kühlsysteme zur Flüssigkeitsimmersionskühlung sind beispielsweise als Zweiphasen-Tauchkühlsysteme eine aktive Kühllösung für Elektronikbauteile, die im Betrieb viel Wärme erzeugen. Beim Eintauchen der Bauteile in ein Wärmeübertragungsfluid, das meist einen relativ niedrigen Siedepunkt hat, kann die vom elektronischen Bauteil erzeugte Wärme das umgebende flüssige Wärmeübertragungsfluid verdampfen, wodurch Wärme von dem elektronischen Bauteil abgeführt wird. Eine Kondensatoreinrichtung verflüssigt das dampfförmige Wärmeübertragungsfluid, welches dann in das Reservoir zur Kühlung zurückgeführt wird.

Aus der Druckschrift US 10 512 192 B2 ist ein zweiphasiges Tauchkühlsystem, mit einem Kühlbecken bekannt. Eine Kondensationskammer, in der das beim Kühlvorgang entstehende gasförmige Fluid kondensiert wird, steht in Verbindung mit dem flüssigen Fluid im Kühlbecken. Eine Dampfumleitungsstruktur ist hierbei über den wärmeerzeugenden Elektronikkomponenten angeordnet, die sich innerhalb des Kühlmediums im Kühlbecken befinden. Das verdampfte Fluid wird mittels der Dampfumleitungsstruktur in die Kondensationskammer zur Verflüssigung geleitet.

Des Weiteren ist aus der Druckschrift US 10 477 726 B1 ein Kühlsystem für Computerkomponenten bekannt. Im Innenraum eines druckgesteuerten Behälters wird der Innendruck auf bis zu 650 hPa reduziert. Im Behälter befindet sich ein wärmeleitendes, dielektrisches Wärmeübertragungsfluid in flüssiger und gasförmiger Phase, welches bei Atmosphärendruck einen Siedepunkt unter 80 °C aufweist. Im Behälter sind Computerkomponenten angeordnet, die zumindest teilweise in die flüssige Phase des Fluids eingetaucht sind. Mittels eines Kondensators wird das durch die Wärmeentwicklung der Computerkomponenten verdampfte dielektrische Gasphasenfluid zu dielektrischem Flüssigphasenfluid kondensiert.

In der Druckschrift US 2019 / 0 008 077 A1 ist ein Flüssigkeits-Tauchkühlsystem mit den Merkmalen des Oberbegriffs von Anspruch 1, mit einem Flüssigkeitstank zur Kühlung von elektronischen Schaltkreisen mit einer Kühlvorrichtung beschrieben. Die Kühlvorrichtung umfasst einen Kühler, der einen Gasraum zwischen Deckel und dem Flüssigkeitsspiegel eines Kühlmittels kühlt, in dem die elektronischen Schaltkreise eingetaucht sind. Zur Wärmeabfuhr weist der Kühler ein Einlassrohr und ein Auslassrohr für Kühlwasser auf, welche an Durchtrittsöffnungen durch die Wandung des Flüssigkeitstanks geführt sind. Das Einlassrohr und Auslassrohr sind mittels Befestigungsplatten an den Durchtrittsöffnungen mit der Wandung des Flüssigkeitstanks verbunden. Jede Befestigungsplatte hat eine Scheibenform mit einem Zentralloch, durch welches das Einlassrohr bzw. das Auslassrohr geführt ist, und Bohrungen für Verschraubungen mit der Wandung des Flüssigkeitstanks.

Auch die Druckschrift US 2014 / 0 218 858 A1 offenbart ein Tauchkühlsystem, bei dem Fluidleitungen durch die Wandung eines Flüssigkeitstanks zur Kühlung von elektronischen Bauteilen hindurchgeführt sind.

Der Erfindung liegt die Aufgabe zugrunde, ein Kühlsystem zur Flüssigkeitsimmersionskühlung von elektronischen Bauteilen bezüglich der Stabilität der Behälterkonstruktion weiterzubilden.

Die Erfindung wird durch die Merkmale des Anspruchs 1 wiedergegeben. Die weiteren rückbezogenen Ansprüche betreffen vorteilhafte Aus- und Weiterbildungen der Erfindung.

Die Erfindung schließt ein Kühlsystem zur Flüssigkeitsimmersionskühlung von elektronischen Bauteilen ein. Das Kühlsystem umfasst einen Behälter mit einer Behälterwandung, der im Inneren ein Reservoir für flüssiges Wärmeübertragungsfluid aufweist und in dem Positioniereinrichtungen für elektronische Bauteile angeordnet sind, wobei der Behälter einen Gasraum für gasförmiges Wärmeübertragungsfluid aufweist.

Im Gasraum des Behälters befindet sich zur Verflüssigung von gasförmigem Wärmeübertragungsfluid eine Wärmeaustauschereinrichtung mit Wärmeaustauscherrohren, wobei die Wärmeaustauscherrohre auf ihrer Außenseite eine Außenberippung aufweisen.

Die Wärmeaustauscherrohre treten an Durchtrittsstellen in die Behälterwandung ein oder durch die Behälterwandung hindurch. An diesen Durchtrittsstellen weisen die Wärmeaustauscherrohre eine stoffschlüssige Verbindung mit der Behälterwandung auf.

Das gasförmige Wärmeübertragungsfluid des Gasraumes steht mit dem flüssigen Wärmeübertragungsfluid des Reservoirs an einer Phasengrenze in Kontakt. Die Oberfläche des flüssigen Wärmeübertragungsfluids im Reservoir bildet dabei die Phasengrenze zum gasförmigen Wärmeübertragungsfluid im Gasraum.

Mit anderen Worten: Die Wärmeaustauscherrohre können innerhalb der Durchtrittsstellen, an denen sie in die Behälterwandung ein oder durch die Behälterwandung hindurchtreten eine glatte Außenseite oder ebenfalls eine Außenberippung aufweisen. Diese Außenberippung wird durch das Material für eine stoffschlüssige Verbindung umschlossen und so ein Durchtritt von Gas oder Flüssigkeit hermetisch abgedichtet. Bevorzugt ist ein Einschmelzen der durch eine Außenberippung ausgeprägten Außenkontur der Rohre in die Behälterwandung. Zum reinen Stoffschluss können auch Kombination zusammen mit Kraftschluss und Formschluss in vorteilhafter Weise eingesetzt werden.

Zur Außenberippung kann ein Wärmeaustauscherrohr zudem wahlweise eine Innenstruktur aufweisen. Die Innenstruktur kann in Gestalt einer innen umlaufenden Helix mit einem vorgegebenen Drallwinkel ausgeführt sein. Für den Fall, dass die Außenseite der Wärmeaustauscherrohre eine spiralig umlaufende Außenberippung aufweist, kann die Steigung der umlaufenden Außenberippung gleich, geringer oder größer als die durch den Drallwinkel vorgegebene Steigung der umlaufenden Helix ausgebildet sein. Beide Strukturen können sich folglich dahingehend unterscheiden, dass zur stoffschlüssigen Verbindung der Außenseite eines Wärmeaustauscherrohres mit der Behälterwandung die Gestaltung der Außenberippung und der Innenstruktur unabhängig voneinander gestaltet und so optimiert werden können.

Zur Optimierung des Wärmeaustauschs sind beiden Strukturen jedoch gewisse Grenzen vorgegeben. So liegt das Verhältnis der maximalen Strukturhöhe der Außenberippung und der maximalen Strukturhöhe der Innenstruktur für Verflüssigerrohre bevorzugt im Bereich von 1,25 bis 5 und für Verdampferrohre bevorzugt im Bereich von 0,5 bis 2.

Zudem kann das Kühlsystem vorteilhafterweise eine Steuereinrichtung aufweisen, die dafür ausgelegt ist, um den Betrieb der Fluidzirkulation beispielsweise als Funktion der Temperatur des Wärmeübertragungsfluids und die Druckverhältnisse im Behälter zu regeln. Mittels Sensoren werden von der Steuereinrichtung eine Überwachung und Steuerung von Druck, Temperatur, Leitfähigkeit sowie alle verfahrensrelevanten Parameter vorgenommen.

Die Erfindung geht dabei von der Überlegung aus, dass durch die stoffschlüssige Verbindung der Wärmeaustauscherrohre mit der Behälterwandung eine besondere Stabilität der gesamten Konstruktion dauerhaft erlangt wird. Durch die erfindungsgemäße direkte Verbindung können an den Durchtrittsstellen der Behälterwandung die aus Stand der Technik bekannten Dichtungsvorrichtungen, wie beispielsweise O-Ringdichtungen, entfallen. Durch die stoffschlüssige feste Verbindung der Wärmeaustauscherrohre und der Behälterwandung ist es auch möglich, gegenüber den sonst üblichen technischen Lösungen die Behälterwandung zu reduzieren, da die Wärmeaustauscherrohre quasi Verstrebungen darstellen und so zur Formstabilität des gesamten Kühlsystems beitragen. Die erfindungsgemäße Lösung unterstützt insbesondere auch die Druckfestigkeit im Betrieb des Systems sowohl hinsichtlich Unterdruck als auch Überdruck in einem hermetisch abgeschlossenem Kühlsystem.

Die Anordnung der Wärmeaustauscherrohre im Behälter ist quasi frei wählbar. Hieraus ergibt sich die Möglichkeit, bevorzugt die Wärmeaustauscherrohre auch im Gasraum nahe der Oberfläche des flüssigen Wärmeübertragungsfluids zu platzieren, insbesondere an den Stellen, an denen eine besonders effiziente Wärmeübertragung nötig ist. Die Wärmeaustauscherrohre übernehmen folglich mehrere Funktionen hinsichtlich mechanischer Stabilität verbunden mit einer effizienten Wärmeübertragung. Der besondere Vorteil besteht darin, dass die erfindungsgemäße Lösung zu einer Optimierung hinsichtlich einer deutlichen Materialeinsparung einhergehend mit einer signifikanten Leistungssteigerung führt.

Im Behälter sind die Elektronikbauteile in für eine Kühlung geeigneter Weise in einem Reservoir von flüssigem Wärmeübertragungsfluid angeordnet, welche durch Verdampfung dieses flüssigen Fluids gekühlt werden. Die Wärmeaustauschereinrichtung des Kühlsystems kann zur Bildung von flüssigem Wärmeübertragungsfluid im Gasraum des Behälters wahlweise in Form von vorteilhaft verteilt angeordneten Einzelrohren oder auch als Rohrbündel ausgeführt sein. Hierbei können auch mehrere Rohrbündel quasi als Module im Gasraum des Behälters verteilt angeordnet sein. Diese besitzen jeweils nach außen eine stoffschlüssige Verbindung mit der Behälterwandung an Durchtrittsstellen der Behälterwandung.

An den Durchtrittsstellen sind die Wärmeaustauscherrohre auch für eine Reinigung von außen zugänglich. Mit einer geeigneten, außerhalb des Behälters liegenden Verbindungstechnik, kann auch bei einer Reinigung einzelner Rohre die Anlage mit reduzierter Kühlleistung weiterbetrieben werden. Die Verteilung und Einleitung des Kühlmediums kann auf diese Weise vollständig außerhalb des Behälters erfolgen.

In bevorzugter Ausgestaltung der Erfindung kann die Außenberippung unmittelbar an die Behälterwandung angrenzen oder mit dieser in Kontakt treten. Dies tritt insbesondere dann auf, wenn die Wärmeaustauscherrohre innerhalb der Durchtrittsstellen, an denen sie in die Behälterwandung ein oder durch die Behälterwandung hindurchtreten immer noch eine Außenberippung aufweisen. An die stoffschlüssige Verbindung der Rohre mit der Behälterwandung verbleibt dann unmittelbar angrenzend die Außenberippung enthalten. Aber auch bei Wärmeaustauscherrohren mit nicht berippten Enden werden die Rohrenden zur stoffschlüssigen Verbindung so weit in die vorgesehenen Durchtrittsstellen eingeführt, dass die angrenzende Außenberippung unmittelbar bis an die Behälterwandung heranreicht oder mit dieser in Kontakt tritt. Dies hat den besonderen Vorteil, dass im Inneren des Behälters die Wärmeaustauscherrohre für eine effiziente Wärmeübertragung eine vollständige Außenberippung aufweisen.

Vorteilhafterweise kann die stoffschlüssige Verbindung gasdicht und druckbeständig ausgeführt sein. Über die Funktionen hinsichtlich mechanischer Stabilität verbunden mit einer effizienten Wärmeübertragung hinaus ist eine hermetische Abdichtung zur Verhinderung eines Fluidaustausches mit der Umgebung in jedem Betriebsmodus wichtig.

Erfindungsgemäß weisen die Wärmeaustauscherrohre in den Durchtrittsstellen einen Rohrinnendurchmesser D2 auf, der größer ist als der Rohrinnendurchmesser D1 der Wärmeaustauscherrohre außerhalb der Durchtrittsstellen.

Wenn die Wärmeaustauscherrohre innerhalb der Durchtrittsstellen, an denen sie in die Behälterwandung ein oder durch die Behälterwandung hindurchtreten immer noch eine Außenberippung aufweisen, liegt verfahrensseitig eine Aufweitung des Wärmeaustauscherrohres mit der Folge eines vergrößerten Rohrinnendurchmessers D2 zugrunde. Durch eine Aufweitung wird dann innerhalb einer Durchtrittsstelle die Außenberippung gequetscht. Dennoch sorgt die stoffschlüssige Verbindung letztendlich für eine stabile hermetische Abdichtung.

Auch bei Wärmeaustauscherrohren mit nicht berippten Enden werden die Rohrenden soweit zur stoffschlüssigen Verbindung in den Durchtrittsstellen aufgeweitet und zusätzlich stoffschlüssig stabilisiert und abgedichtet.

Bei einer vorteilhaften Ausführungsform der Erfindung können die Wärmeaustauscherrohre in die Behälterwandung gelötet, geklebt oder geschweißt sein. Zu den genannten bevorzugten Verbindungsarten können auch weitere hinzutreten, welche die Wärmeaustauscherrohre eine stoffschlüssige Verbindung mit der Behälterwandung zuverlässig fügen.

Prinzipiell kann die Außenberippung auf der Außenseite der Wärmeaustauscherrohre bevorzugt in umfänglicher Richtung oder in axialer Richtung parallel zur Rohrachse verlaufen. Bei einer vorteilhaften Ausführungsform der Erfindung kann die Außenseite der Wärmeaustauscherrohre eine spiralig umlaufende Außenberippung aufweisen. Bei einer spiraligen Außenberippung muss lediglich der spiralig mit einer Außenberippung umlaufende Kanal durch die stoffschlüssige Verbindung zuverlässig abgedichtet werden.

Bei einer vorteilhaften Ausführungsform der Erfindung kann der Behälter als Druckbehälter ausgeführt sein, der mit einem Unterdruck und/oder Überdruck arbeitet. Das Kühlsystem kann sowohl hinsichtlich der vorhandenen mechanischen Stabilität, verbunden mit einer effizienten Wärmeübertragung unter Überdruck als auch unter Unterdruck, variabel in seinem Betriebsmodus gegenüber der Umgebungsatmosphäre eingestellt werden. Ein in der Praxis typischer Betriebsmodus ist, den Innendruck unter den Atmosphärendruck und über 650 Torr zu reduzieren, wobei das dielektrische Fluid typischerweise einen Siedepunkt unter etwa 80°C aufweist.

Auch wenn regelmäßig für die Wärmeaustauscherrohre ein geeignetes einheitliches Material bevorzugt ist, kann in vorteilhafter Ausgestaltung der Erfindung mindestens ein erstes Wärmeaustauscherrohr aus einem ersten Material bestehen und mindestens ein zweites Wärmeaustauscherrohr aus einem zweiten Material bestehen, welches sich vom ersten Material unterscheidet. Hinsichtlich der mechanischen Stabilität können Stahlrohre mit besonders hoher Festigkeit einen besonderen Vorteil bieten. Kupferrohre bewirken hingegen eine Optimierung hinsichtlich einer effizienten Wärmeübertragung. Auch andere Materialien, wie beispielsweise Titan, Aluminium, Aluminiumlegierungen sowie Kupfer-Nickel-Legierungen kommen in Betracht.

Vorteilhafterweise kann das erste Material Kupfer und das zweite Material Stahl sein. Eine geeignete Kombination an einzelnen Wärmeaustauscherrohren bestehend aus diesen beiden Materialien führen zu einer weiteren Optimierung hinsichtlich der vorhandenen mechanischen Stabilität verbunden mit einer effizienten Wärmeübertragung.

Ausführungsbeispiele der Erfindung werden anhand der schematischen Zeichnungen näher erläutert.

Darin zeigen:
- Fig. 1: schematisch eine Frontansicht eines Kühlsystems,
- Fig. 2: schematisch eine Frontansicht eines Ausschnitts der Behälterwandung mit Durchtrittsstelle, und
- Fig.3: schematisch einen senkrechten Schnitt der Behälterwandung in der Ebene der Durchtrittsstelle eines Wärmeaustauscherrohres.

Einander entsprechende Teile sind in allen Figuren mit denselben Bezugszeichen versehen.

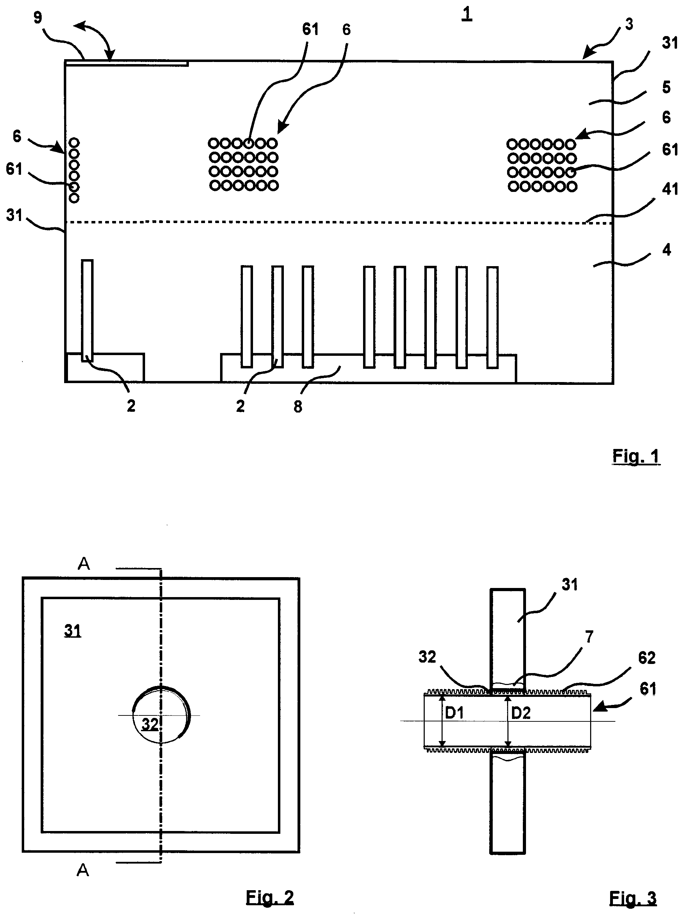

Fig. 1 zeigt schematisch eine Frontansicht eines Kühlsystems 1 zur zweiphasen Flüssigkeitsimmersionskühlung von elektronischen Bauteilen 2. Das Kühlsystem 1 umfasst einen Behälter 3 und eine Schleuseneinrichtung 9 zum Austausch elektronischer Bauteile 2. Die elektronischen Bauteile 2 tauchen in das im Inneren des Behälters 3 befindliche Reservoir 4 mit flüssigem dielektrischen Wärmeübertragungsfluid ein. Über der Oberfläche 41 des flüssigen Wärmeübertragungsfluids befinden sich die Wärmeaustauschereinrichtungen 6 im Gasraum 5 des Behälters 3.

Das Kühlsystem 1 umfasst eine Wärmeaustauschereinrichtung 6 mit Wärmeaustauscherrohren 61 im Gasraum 5 des Behälters 3 zur Verflüssigung von gasförmigem Wärmeübertragungsfluid. Die Wärmeaustauscherrohre 61 weisen auf der Außenseite eine aufgrund der geringen Strukturhöhe in dieser Figur nicht dargestellte Außenberippung auf. Die Wärmeaustauscherrohre 61 treten an Durchtrittsstellen in die Behälterwandung 31 ein oder durch die Behälterwandung 31 hindurch. An diesen Durchtrittsstellen weisen die Wärmeaustauscherrohre 61 eine stoffschlüssige Verbindung mit der Behälterwandung 31 auf. Die Anordnung der Wärmeaustauscherrohre im Behälter ist im Prinzip frei wählbar. Im Behälter sind die Wärmeaustauscherrohre 61 im Gasraum 5 jedoch bevorzugt in Form von Bündeln oder zeilig an mehreren Stellen angeordnet, um eine mechanische Stabilität verbunden mit einer effizienten Wärmeübertragung zu bewirken.

Im Kühlsystem 1 kann ein in Fig. 1 nicht dargestelltes automatisches Bestückungssystem im Behälter 3 angeordnet sein, mit dem für einen Austausch die elektronischen Bauteile 2 von der Schleuseneinrichtung 9 an die Betriebsposition 31 in das Reservoir 4 mit flüssigem Wärmeübertragungsfluid transportiert werden können. Einen Transport der elektronischen Bauteile 2 können Greifarme von Robotern oder lineare Transportsysteme vornehmen, welche automatisiert auszutauschende elektronische Bauteile 2 aus der Betriebsposition aus der Positioniereinrichtung 8 abholen. In umgekehrter Reihenfolge werden einzubauende betriebsbereite elektronische Bauteile 2 mittels dem Bestückungssystem in die Betriebsposition in die Positioniereinrichtung 8 überführt.

Fig. 2 zeigt schematisch eine Frontansicht eines Ausschnitts der Behälterwandung 31 mit Durchtrittsstelle 32. An der Durchtrittsstelle 32 ist die Ausnehmung der Behälterwandung 31 bevorzugt gerade so groß, dass ein Wärmeaustauscherrohr eingebracht werden kann und dort stoffschlüssig verbunden wird. Klebe- und Lötverbindungen können an der Durchtrittsstelle 32 über die gesamte Wandstärke erfolgen. Schweißverbindungen können außen und/oder innenseitig angeordnet werden. Bei günstigem Schmelzfluss kann sich auch bei einseitiger Schweißung von der Außen- oder Innenseite des Behälters eine durch die gesamte Wandstärke erfolgende Schweißverbindung an der Durchtrittsstelle 32 einstellen.

Fig. 3 zeigt schematisch einen senkrechten Schnitt der Behälterwandung 31 entlang der Schnittlinie A-A aus Figur 2 in der Ebene der Durchtrittsstelle eines Wärmeaustauscherrohres 61. Das dargestellte Wärmeaustauscherrohr 61 weist auf der Außenseite eine Außenberippung 62 auf. Das Wärmeaustauscherrohr 61 tritt an der Durchtrittsstelle 32 durch die Behälterwandung 31 hindurch. An dieser Durchtrittsstelle weist das Wärmeaustauscherrohr 61 eine durchgängige Außenberippung 62 sowie eine stoffschlüssige Verbindung 7 in Gestalt einer durchgängigen Schweißnaht mit der Behälterwandung 31 auf. Je nach Materialkombination aus der Behälterwandung 31 und aus dem Wärmeaustauscherrohr 61 kann es an der Schweißstelle zu vorteilhaften intermetallischen neuen Phasenbildungen im Schmelzebad kommen. Ein geeignetes Verfahren zur Herstellung einer stoffschlüssigen Verbindung mit einem örtlich begrenzten Schmelzfluss stellt beispielsweise das Laserschweißen dar.

### Bezugszeichenliste

- 1: Kühlsystem
- 2: elektronisches Bauteil
- 3: Behälter
- 31: Behälterwandung
- 32: Durchtrittsstelle
- 4: Reservoir für flüssiges Wärmeübertragungsfluid
- 41: Oberfläche des flüssigen Wärmeübertragungsfluids
- 5: Gasraum für gasförmiges Wärmeübertragungsfluid
- 6: Wärmeaustauschereinrichtung
- 61: Wärmeaustauscherrohr
- 62: Außenberippung
- 7: stoffschlüssige Verbindung
- 8: Positioniereinrichtung
- 9: Schleuseneinrichtung
- A-A: Schnittlinie

## Patentansprüche

1. Kühlsystem (1) zur Flüssigkeitsimmersionskühlung von elektronischen Bauteilen (2), umfassend
- einen Behälter (3) mit einer Behälterwandung (31), der im Inneren ein Reservoir (4) für flüssiges Wärmeübertragungsfluid aufweist und in dem Positioniereinrichtungen (8) für elektronische Bauteile (2) angeordnet sind, wobei der Behälter (3) einen Gasraum (5) für gasförmiges Wärmeübertragungsfluid aufweist,
- eine Wärmeaustauschereinrichtung (6) mit Wärmeaustauscherrohren (61) im Gasraum (5) des Behälters (3) zur Verflüssigung von gasförmigem Wärmeübertragungsfluid, wobei die Wärmeaustauscherrohre (61) auf ihrer Außenseite eine Außenberippung (62) aufweisen und an Durchtrittsstellen (32) in die Behälterwandung (31) eintreten oder durch die Behälterwandung (31) hindurchtreten,
**dadurch gekennzeichnet,**
- **dass** die Wärmeaustauscherrohre (61) in den Durchtrittsstellen (32) einen Rohrinnendurchmesser D2 aufweisen, der größer ist als der Rohrinnendurchmesser D1 der Wärmeaustauscherrohre (61) außerhalb der Durchtrittsstellen (32), und
- **dass** an diesen Durchtrittsstellen (32) die Wärmeaustauscherrohre (61) eine stoffschlüssige Verbindung (7) mit der Behälterwandung (31) aufweisen.

2. Kühlsystem (1) nach Anspruch 1, **dadurch gekennzeichnet, dass** die Außenberippung (62) an diesen Durchtrittsstellen (32) unmittelbar an die Behälterwandung (31) angrenzt oder mit dieser in Kontakt tritt.

3. Kühlsystem (1) nach Anspruch 1 oder 2, **dadurch gekennzeichnet, dass** die stoffschlüssige Verbindung (7) gasdicht und druckbeständig ausgeführt ist.

4. Kühlsystem (1) nach einem der Ansprüche 1 bis 3, **dadurch gekennzeichnet, dass** die Wärmeaustauscherrohre (61) in die Behälterwandung (31) gelötet, geklebt oder geschweißt sind.

5. Kühlsystem (1) nach einem der Ansprüche 1 bis 4, **dadurch gekennzeichnet, dass** die Außenseite der Wärmeaustauscherrohre (61) eine spiralig umlaufende Außenberippung (62) aufweist.

6. Kühlsystem (1) nach einem der Ansprüche 1 bis 5, **dadurch gekennzeichnet, dass** der Behälter (3) als Druckbehälter ausgeführt ist, der mit einem Unterdruck und/oder Überdruck arbeitet.

7. Kühlsystem (1) nach einem der Ansprüche 1 bis 6, **dadurch gekennzeichnet, dass** mindestens ein erstes Wärmeaustauscherrohr (61) aus einem ersten Material besteht und mindestens ein zweites Wärmeaustauscherrohr (61) aus einem zweiten Material besteht, welches sich vom ersten Material unterscheidet.

8. Kühlsystem (1) nach Anspruch 7, **dadurch gekennzeichnet, dass** das erste Material Kupfer und das zweite Material Stahl ist.

## Claims

1. Cooling system (1) for the liquid immersion cooling of electronic components (2), comprising
- a container (2) which has container walls (31) and which has at the inner side a tank (4) for liquid heat transfer fluid and in which positioning devices (8) for electronic components (2) are arranged,
wherein the container (3) has a gas compartment (5) for gaseous heat transfer fluid,
- a heat exchange device (6) having heat exchange pipes (61) in the gas compartment (5) of the container (3) for liquefying gaseous heat transfer fluid, wherein the heat exchange pipes (61) have at the outer side thereof an outer ribbing (62) and enter the container walls (31) at passage locations (32) or pass through the container walls (31), **characterised in that**
- the heat exchange pipes (61) have in the passage locations (32) a pipe inner diameter D2 which is greater than the pipe inner diameter D1 of the heat exchange pipes (61) outside the passage locations (32), and
- **in that** at these passage locations (32) the heat exchange pipes (61) have a materially engaging connection (7) to the container walls (31).

2. Cooling system (1) according to claim 1, **characterised in that** the outer ribbing (62) at these passage locations (32) directly adjoins the container walls (31) or comes into contact with them.

3. Cooling system (1) according to claim 1 or 2, **characterised in that** the materially engaging connection (7) is constructed to be gas-tight and pressure-resistant.

4. Cooling system (1) according to any one of claims 1 to 3, **characterised in that** the heat exchange pipes (61) are soldered, adhesively bonded or welded into the container walls (31).

5. Cooling system (1) according to any one of claims 1 to 4, **characterised in that** the outer side of the heat exchange pipes (61) has a helically circumferential outer ribbing (62).

6. Cooling system (1) according to any one of claims 1 to 5, **characterised in that** the container (3) is in the form of a pressure container which functions at a reduced pressure and/or excess pressure.

7. Cooling system (1) according to any one of claims 1 to 6, **characterised in that** at least a first heat exchange pipe (61) comprises a first material and at least a second heat exchange pipe (61) comprises a second material which is different from the first material.

8. Cooling system (1) according to claim 7, **characterised in that** the first material is copper and the second material is steel.

## Revendications

1. Système de refroidissement (1) pour le refroidissement de composants électroniques (2) par immersion dans un liquide, comprenant
- un récipient (3) avec une paroi de récipient (31), qui présente à l'intérieur un réservoir (4) pour un fluide caloporteur liquide et dans lequel sont agencés des dispositifs de positionnement (8) pour des composants électroniques (2), le récipient (3) présentant un espace gazeux (5) pour un fluide caloporteur gazeux,
- un dispositif d'échange thermique (6) avec des tubes d'échange thermique (61) dans l'espace gazeux (5) du récipient (3) pour liquéfier le fluide caloporteur gazeux, les tubes d'échange thermique (61) présentant sur leur face extérieure un nervurage extérieur (62), et pénètrent dans la paroi de récipient (31) au niveau de points de passage (32) ou traversent la paroi de récipient (31),
**caractérisé en ce que**
- les tubes d'échange thermique (61) présentent, dans les points de passage (32), un diamètre intérieur D2 supérieur au diamètre intérieur D1 des tubes d'échange thermique (61) à l'extérieur des points de passage (32), et
- aux points de passage (32), les tubes d'échange thermique (61) présentent une liaison par adhérence (7) avec la paroi de récipient (31).

2. Système de refroidissement (1) selon la revendication 1, **caractérisé en ce que** le nervurage extérieur (62) au niveau de ces points de passage (32) est directement adjacent à la paroi de récipient (31) ou entre en contact avec celle-ci.

3. Système de refroidissement (1) selon la revendication 1 ou 2, **caractérisé en ce que** la liaison par adhérence (7) est réalisée de manière étanche au gaz et résistante à la pression.

4. Système de refroidissement (1) selon l'une des revendications 1 à 3, **caractérisé en ce que** les tubes d'échange thermique (61) sont soudés, collés ou brasés dans la paroi de récipient (31).

5. Système de refroidissement (1) selon l'une des revendications 1 à 4, **caractérisé en ce que** la face extérieure des tubes d'échange thermique (61) présente un nervurage extérieur (62) s'étendant en spirale.

6. Système de refroidissement (1) selon l'une des revendications 1 à 5, **caractérisé en ce que** le récipient (3) est conçu comme un récipient sous pression qui fonctionne avec une dépression et/ou une surpression.

7. Système de refroidissement (1) selon l'une des revendications 1 à 6, **caractérisé en ce qu'**au moins un premier tube d'échange thermique (61) est constitué d'un premier matériau et au moins un deuxième tube d'échange thermique (61) est constitué d'un deuxième matériau qui diffère du premier matériau.

8. Système de refroidissement (1) selon la revendication 7, **caractérisé en ce que** le premier matériau est du cuivre et le deuxième matériau est de l'acier.
